Europäisches Patentamt

European Patent Office

Office européen des brevets

(11) Publication number: **0 436 337 A2**

# EUROPEAN PATENT APPLICATION

(21) Application number: **90313745.3**

(22) Date of filing: **17.12.90**

(51) Int. Cl.5: **H01L 21/66, H01L 23/528**

(30) Priority: **22.12.89 US 457032**

(43) Date of publication of application:
**10.07.91 Bulletin 91/28**

(84) Designated Contracting States:
**DE FR GB IT**

(71) Applicant: **RAYTHEON COMPANY**
**141 Spring Street**
**Lexington Massachusetts 02173(US)**

(72) Inventor: **Schindler, Manfred J.**
**28 Brookdale Road**
**Newton, Massachusetts(US)**

(74) Representative: **Jackson, David Spence et al**
**REDDIE & GROSE 16, Theobalds Road**
**London, WC1X 8PL(GB)**

(54) Technique for simplified testing of semiconductor circuits.

(57) DC testing of semiconductor circuits is carried out while such circuits are supported by a semiconductor substrate (12) during their fabrication process, the semiconductor substrate (12) supporting a plurality of integrated circuits (13) each including a plurality of the semiconductor circuits, and each semiconductor circuit having at least one electrode (14a, 14b, 14c). Such electrodes (14a, 14b, 14c) of one of the integrated circuits (13) are connected with such electrodes of another one of the integrated circuits.

By interconnecting the electrodes, several integrated circuits may be tested in parallel, thereby decreasing the overall time and cost associated with the DC testing, while the circuits are supported by the semiconductor substrate (12). The interconnection may be in the form of conducting regions (15) of the substrate (12) in contact with the electrodes (14) and a grid (16) of metal conductors (17a, 17b, 17c; 23a, 23b, 23c).

Fig. 1

## TECHNIQUE FOR SIMPLIFIED TESTING OF SEMICONDUCTOR CIRCUITS

Background of the Invention

This invention relates generally to semiconductor integrat circuits and more particularly to DC testing of such circuits.

As is known in the art, an integrated circuit generally includes a plurality of semiconductor devices supported on a common semiconductor substrate. One semiconductor substrate will typically support a large number of integrated circuits. For example, a 3 inch semiconductor substrate will often support hundreds to thousands of integrated circuits. Once the integrated circuit fabrication is completed, the semiconductor substrate is divided up into individual integrate circuits.

As is further known in the art, it is common practice to perform DC tests on integrated circuits after various stages of fabrication, while the circuits are still supported by the common semiconductor substrate. Testing of semiconductor devices and circuits after various stages of the fabrication process is an important procedure as it aids in the selection of fully functional integrated circuits. Although further testing is conducted once the semiconductor substrate has been divided into discrete integrated circuits, the substrate level testing is a valuable first pass evaluation, as it will eliminate the final, more extensive testing of devices which have previously been determined not to meet specifications.

One technique known in the art for testing such circuits still supported by a common substrate is to individually test each device of each circuit. Difficulty arises not only from the substantial time required to test the large quantity of circuits and their devices, but also from the number of test probes required for a complete analysis.

One type of semiconductor device is a monolithic microwave integrated circuit (MMIC) which processes signals having frequencies in the microwave range. Examples of such circuits include amplifiers, phase shifters, and switching circuits. For example, a 1x2 switching MMIC may require four field effect transistors (FETs) to be tested using 5 to 7 test probes. More complex circuits such as 1x4 or 2x4 switches require correspondingly more test probes.

Thus, as the required number of test probes on a test fixture increases to accommodate more complex circuits, the cost and difficulty of using the fixture also increases. Furthermore, there are practical limitations in the number of probe pins per fixture that vendors are currently able to supply..

The result of the above described testing problem has, in some cases, been a decline in the completeness of such testing. Although time and money may appear saved by less thorough testing after various stages of the fabrication process, often that is not the case when defective integrated circuits are not discovered until late in the fabrication and testing processes.

It would therefore be desirable to simplify the testing of integrated circuits while they are still supported by the semiconductor substrate. More specifically, a technique which minimizes the time to test by decreasing the number of test probes required would decrease the overall cost and time associated with the DC testing of integrated circuits.

Summary of the Invention

In accordance with the present invention, a semiconductor substrate supporting a plurality of spaced integrated circuits, with each one of such circuits having an electrode coupled thereto, includes means for interconnecting the electrode of one of the plurality of integrated circuits with the electrode of another one of the plurality of integrated circuits. In one embodiment the means for interconnecting the electrodes is disposed on portions of the substrate which space the integrated circuits. In an alternate embodiment, the means for interconnecting the electrodes is disposed on one of the plurality of integrated circuits as well as in the portions of the substrate which space the integrated circuits.

With such an arrangement, the interconnecting means permits testing of several devices in parallel or the biasing of several devices with only one test probe connection. For example, where the integrated circuits are comprised of field effect transistors (FETs), the gate electrodes of several of such devices may be interconnected thereby allowing the desired biasing of the gate electrodes of several FETs with a single test probe connection. The total number of test probes required for thorough circuit evaluation is thus reduced, also reducing the time and cost associated with such testing.

In accordance with a further aspect of the present invention, an integrated circuit includes a plurality of semiconductor devices, wherein at least one of the devices has an electrode coupled thereto. The electrode is disposed on, and electrically coupled to, a conductive region wherein the conductive region is further disposed between the electrode and an edge of the integrated circuit. With this arrangement, prior to the division of the semiconductor substrate into individual integrated circuits, the conductive regions of adjacent integrated circuits, and therefore the electrodes of the adjacent circuits, may be electrically connected to permit testing of a plurality of the integrated circuits using a single test probe.

Brief Description of the Drawings

The foregoing features of this invention, as well as the invention itself, may be more fully understood from the following detailed description of the drawings, in which:

FIG. 1 is a plan view of a semiconductor substrate supporting a plurality of integrated circuits in accordance with the present invention;

FIG. 2 is an enlarged cross-sectional view taken along lines 2-2 of FIG. 1;

FIG. 3 is a schematic diagram representative of one of the plurality of integrated circuits of FIG. 1;

FIG. 4 is a schematic diagram of an equivalent circuit of the integrated circuit of FIG. 3;

FIG. 5 is a plan view of one of the integrated circuits of FIG. 1 after dicing of the semiconductor substrate of FIG. 1 into individual circuits;

FIG. 6 is a plan view of a semiconductor substrate supporting a plurality of integrated circuits in accordance with a further aspect of the present invention;

FIG. 7 is an enlarged cross-sectional view taken along lines 7-7 of FIG. 6; and

FIG. 8 is a plan view of an integrated circuit after dicing of the semiconductor substrate of FIG. 6 into individual circuits.

Description of the Preferred Embodiments

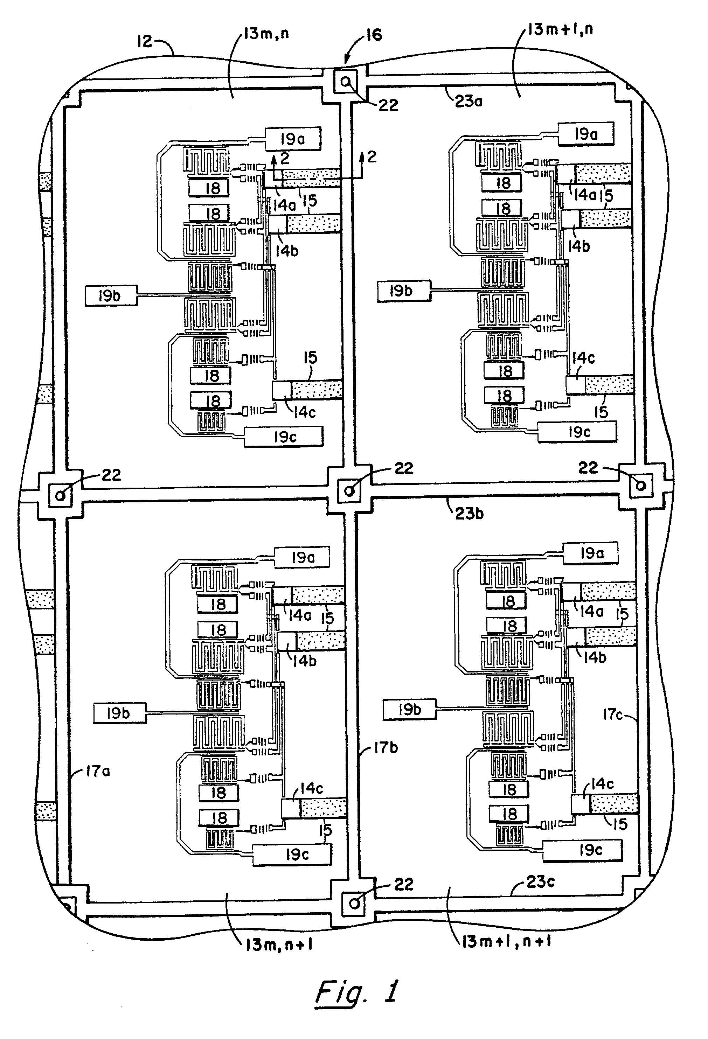

Referring now to FIG. 1, a portion of a semiconductor substrate 12, here comprised of gallium arsenide, is shown supporting a plurality of monolithic microwave integrated circuits $13_{m,n}$ to $13_{m+1,n+1}$. Portions of the substrate 12 space the integrated circuits and provide a grid pattern 16. The substrate 12 supports said circuits $13_{m,n}$ to $13_{m+1,n+1}$ during the fabrication process after which the substrate 12 is divided in order to provide individual integrated circuits $13_{m,n}$ to $13_{m+1,n+1}$. Disposed in the grid pattern 16 of the substrate 12 are a plurality of vertically disposed grid conductors 17a-17c and horizontally disposed grid conductors 23a-23c which are interconnected around optional alignment markers 22 as shown. Here the alignment markers 22 are vias which are used to align the semiconductor substrate 12 during the fabrication process.

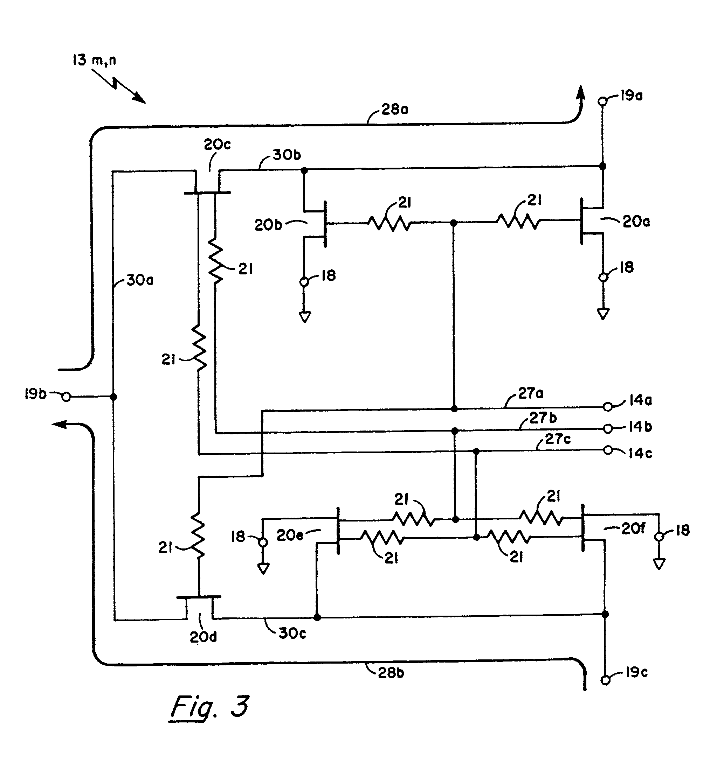

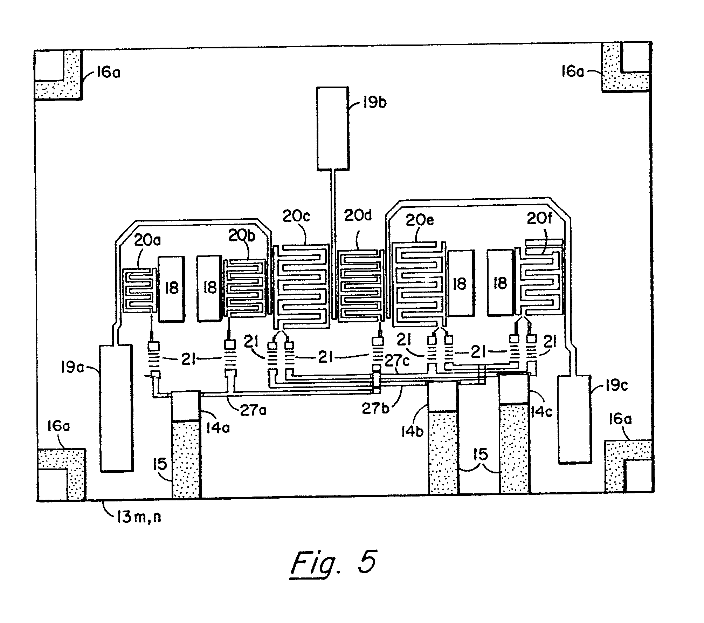

Each one of the individual circuits supported by the substrate 12 including circuits $13_{m,n}$ to $13_{m+1,n+1}$ shown here is a monolithic microwave 1x2 switching circuit as will be described in conjunction with FIGS. 3 and 4. Suffice it here t say that each of the integrated circuits $13_{m,n}$ to $13_{m+1,n+1}$ includes a plurality of field effect transistors 20a-20f (FIG. 3), each having gate, source, and drain electrodes, and a second plurality of resistors 21 (FIG. 3). Each of the integrated circuits $13_{m,n}$ to $13_{m+1,n+1}$ also includes three common gate pads 14a-14c, input/output ports 19a-19c, and source pads 18, all such pads providing points to which external connections are made. Each integrated circuit $13_{m,n}$ to $13_{m+1,n+1}$ further includes conductive regions 15 disposed between and electrically connected with common gate pads 14a-14c and vertically disposed conductors 17a-17c as shown. Conductive regions 15 are also electrically connected with horizontally disposed grid conductors 23a-23c since the vertical conductors 17a-17c are electrically connected with such horizontal grid conductors 23a-23c. The conductive regions 15 are comprised of any conductive material such as metal or suitably doped semiconductor, here GaAs doped with silicon to a concentration greater than about $2 \times 10^{17}$ carriers/cm$^3$.

Here the grid conductors 17a-17c and 23a-23c are comprised of a highly conductive material, preferably a highly conductive metal such as gold. Metal is preferred over other conductors such as doped semiconductor which could be used because metal such as gold will generally have a lower resistivity. The grid conductors 17a-17c and 23a-23c will extend over relatively large lengths of the surface of the substrate. A material having low resistivity is preferred so that a minimal voltage drop, and therefore minimal error, is introduced into DC testing as will be described.

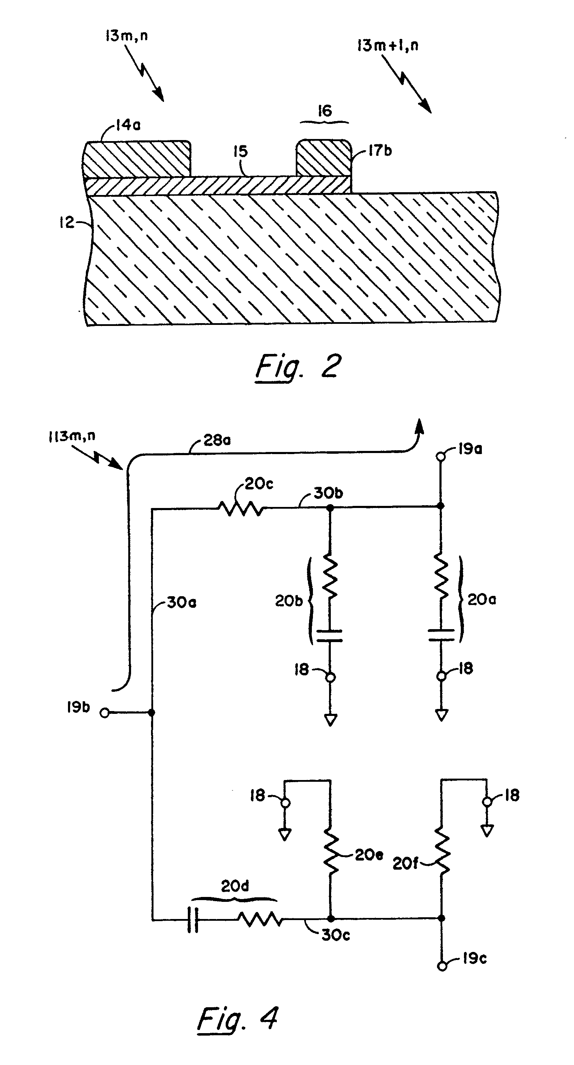

Referring now to FIG. 2, a portion of semiconductor substrate 12 is shown supporting portions of adjacent integrate circuits $13_{m,n}$ and $13_{m+1,n}$. Common gate pad 14a of integrated circuit $13_{m,n}$ is disposed over and in electrical contact with conductive region 15 of doped GaAs as described in conjunction with FIG. 1. Vertical metal grid conductor 17b interconnects the plurality of conductive regions 15, and thus the plurality of common gate pads 14a-14c, as shown in FIG. 1. Grid conductor 17b is disposed in the grid pattern 16 of the semiconductor substrate 12.

Referring now to FIG. 3, a schematic diagram of one of the plurality of monolithic microwave integrated circuits $13_{m,n}$ of FIG. 1, here a 1x2 switching circuit, includes a plurality of electrically interconnected devices, here field effect transistors 20a-20f, each having source, gate, and drain electro (not labelled), and a second plurality of resistors 21. The circuit $13_{m,n}$ further includes input, output, and common ports 19c, 19a, and 19b, respectively, source pads 18, and common gate pads 14a-14c.

Such a circuit couples transmitted and received radio frequency signals between a common port 19b and one of a pair of branch ports 19a, 19c. Thus, here a transmitted signal is coupled along a path 28b from input port 19c to common port 19b, whereas a received signal is coupled along a path 28a, from common port 19b to output port 19a. Here all signal paths include microstrip transmission lines, however transmission media such as coplanar waveguide and lumped element arrangement could alternately be used.

Each of the six FETs 20a-20f has a gate electrode (not labelled), or two such electrodes in the case of dual gate FETs 20c, 20e, 20f, connected to the first end of a resistor 21, with the second end of the resistor 21 connected to one of the three common gate pads 14a-14c along one of the gate bias paths 27a-27c. Specifically, the gate electrodes of FETs 20a,20b, and 20d are each connected through resistors 21 and along gate bias path 27a, to common gate pad 14a. FETs 20c, 20e, and 20f are dual gate FETs, and are arranged such that the first gate electrode of each of these FETs is connected through resistors 21, along gate bias path 27b, to common gate pad 14b, and the second gate electrode of each of these devices is connected via resistors 21, along path 27c, to common gate pad 14c.

The source electrodes (not labelled) of FETs 20a, 20b, 20e and 20f, are connected directly to source pads 18 and here to a reference potential. The drain electrodes of FETs 20a and 20b are connected to the source electrode of FET 20c and to output port 19a via signal path 30b. The drain electrodes of FETS 20d, 20e, and 20f are connected to input port 19c along signal path 30c, and the source electrode of FET 20d and the drain electrode of FET 20c are connected to the common port 19b along signal path 30a. Signal paths 30a-30c and gate bias paths 27a-27c are here microstrip transmission lines but could alternately be other types of transmission media. The operation of such a circuit may be understood in connection with an equivalent circuit $113_{m,n}$ as shown in FIG. 4 where an r.f. signal fed to port 19b is coupled to port 19a but isolated from port 19c in response to control signals fed to the switch $13_{m,n}$.

A bias voltage is applied to the FETS 20a-20f in FIG. 3 from a voltage source not shown. The bias is fed to the gate electrode of single gate FETS 20a, 20b, and 20d or to the pair of gate electrodes in the case of dual gate FETS 20c, 20e, and 20f in order to control conduction between the drain and source electrodes. With depletion mode GaAs metal semiconductor field effect transistors (MESFETs), the gate electrode of a FET in the conducting state is biased at 0 volts with respect to the source and drain electrodes, thus enabling current to flow between the drain and source regions.

In the non-conducting state, the gate electrode is biased beyond a "pinch-off" voltage in order to isolate the drain and source regions from each other thus restricting the flow of current between the drain and source regions. Switching FETs are here modelled as a resistance between the drain and source electrodes in the conducting state, and as a capacitance in series with a resistance between the drain and source electrodes in the nonconducting state. Thus, for the arrangement shown in FIG. 4, a bias of 0 volts is fed to the gates of transistors 20c, 20e, and 20f whereas a bias of approximately negative seven volts is fed to transistors 20a, 20b, and 20d to place such transistors in their non-conducting state as shown. To provide a path between terminals 19b and 19c the opposite states of such bias signals are fed to the transistors.

The above described interconnection of the gate electrodes of the six FETs 20a-20f with common gate pads 14a-14c permits biasing of these gate pads 14a-14c, in order to "open" and "close" signal paths from 19c to 19b and from 19b to 19a, simultaneously for all of the circuits $13_{m,n}$ to $13_{m+l,n+l}$ while still supported by the common substrate 12 and interconnected by the grid 16.

The interconnection of common gate pads 14a-14c of the plurality of integrated circuits as described in conjunction with FIG. 1, permits the biasing of the plurality common gate pads 14a-14c of said circuits $13_{m,n}$ to $13_{m+l,n+l}$ with one test probe connection. For example, one way to test the FETs 20a-20f of a single circuit for shorted drain and source electrodes is to apply the "pinch-off" voltage to the interconnected common gate pads 14a-14c of the transistors, thus keeping the transistors 20a-20f in their non-conducting states. Such testing would be done for example prior to backside processing of the wafer thus common source pads 18, which would be connected to a ground plane (not shown) after such backside processing, would require individual test probes. Five probe connections, in addition to the bias voltage connection, will be sufficient to find any shorted drain to source junction. By having test probe connections at each of the three input/output and common ports 19a-19c, and on two of the source electrodes 18, each FET can be monitored at its drain and source electrodes individually while a signal is applied at the drain electrode. The signal applied to the drain electrode should appear differentially across the drain and source electrodes, indicating no short between the drain and source electrodes. If, however, no voltage drop appears across the drain and source electrodes, a short exists between such electrodes. This test would then be repeated for each additional circuit. By employing this arrangement, two test probes are eliminated from the testing process since the three common gate pads 14a-14c need have only one test probe connection. Corresponding savings in test probe connections would be provided for more complex circuits.

Referring now to FIG. 5, the 1x2 switching circuit $13_{m,n}$ is shown after the division of the semiconductor substrate 12 of FIG. 1 into individual integrated oircuits $13_{m,n}$ to $13_{m+l,n+l}$

As described in conjunction with FIG. 3, each of the nine gate electrodes (not labelled) of the circuit $13_{m,n}$ is electrically connected to the first end of a resistor 21. Here resistors 21 are comprised of a plurality of "open" gate FETS. An "open" gate FET is a FET in which the gate electrode is left "open" or floating. With such an arrangement, the gate potential will tend towards 0 volts, thus biasing the FET to its conducting state, which, as described above can be modelled as a resistor between drain and source electrodes. Each "open" gate FET represents a resistivity of approximately 300 ohms. Therefore, to bias the gate electrode with a typical 1K-2K ohm resistance requires 4 to 6 "open" gate FETS disposed in series. The second ends of resistors 21 are electrically connected, via gate bias paths 27a-27c, to one of three common gate pads 14a-14c such that three of the resistors 21, and thus three gate electrodes, are connected to one of three common gate pads 14a-14c as described in FIG. 3.

Each of the common gate pads 14a-14c of the integrated circuit $13_{m,n}$ is disposed over, and in electrical contact with, a conductive region 15 here comprised of doped GaAs having doping concentration as described in conjunction with FIG. 1. The conductive regions 15 are further disposed between the common gate pads 14a-14c and the edge of the integrated circuit $13_{m,n}$. Prior to the division of the semiconductor substrate 12 into individual integrated circuits $13_{m,n}$ to $13_{m+l,n+l}$, the conductive regions 15 of the plurality integrated circuits would have been interconnected by grid conductors 17a-17c and 23a-23c, as shown in conjunction with FIG. 1, thus electrically interconnecting the plurality of common gate pads 14a-14c.

When the semiconductor substrate 12 is separated into individual integrated circuits $13_{m,n}$ to $13_{m+l,n+l}$ by either etching or sawing for example, the grid conductors 17a-17c and 23a-23c, having been disposed in the grid pattern 16 of the substrate 12 which spaces the integrated circuits and where the separation occurs, are completely removed. However, the conductive regions 15 remain intact on the individual integrated circuits $13_{m,n}$ to $13_{m+l,n+l}$, after the division of the semiconductor substrate 12 as shown on circuit $13_{m,n}$ of FIG. 5.

Also shown in FIG. 5, in each of the corners of the integrated circuit $13_{m,n}$, are small portions 16a of the metal grid conductors 17a-17c and 23a-23c.

These portions 16a are the result of routing the horizontally and vertically disposed grid conductors 17a-17c and 23a-23c around the optional alignment markers 22 here via holes which marked the corners of the integrated circuits $13_{m,n}$ to $13_{m+l,n+l}$ while the circuit were supported by the semiconductor substrate 12. The alignment markers 22 do not appear on the individual integrated circuit $13_{m,n}$ since they would have been removed during the division of the semiconductor substrate 12 into individual integrated circuits $13_{m,n}$ to $13_{m+l,n+l}$.

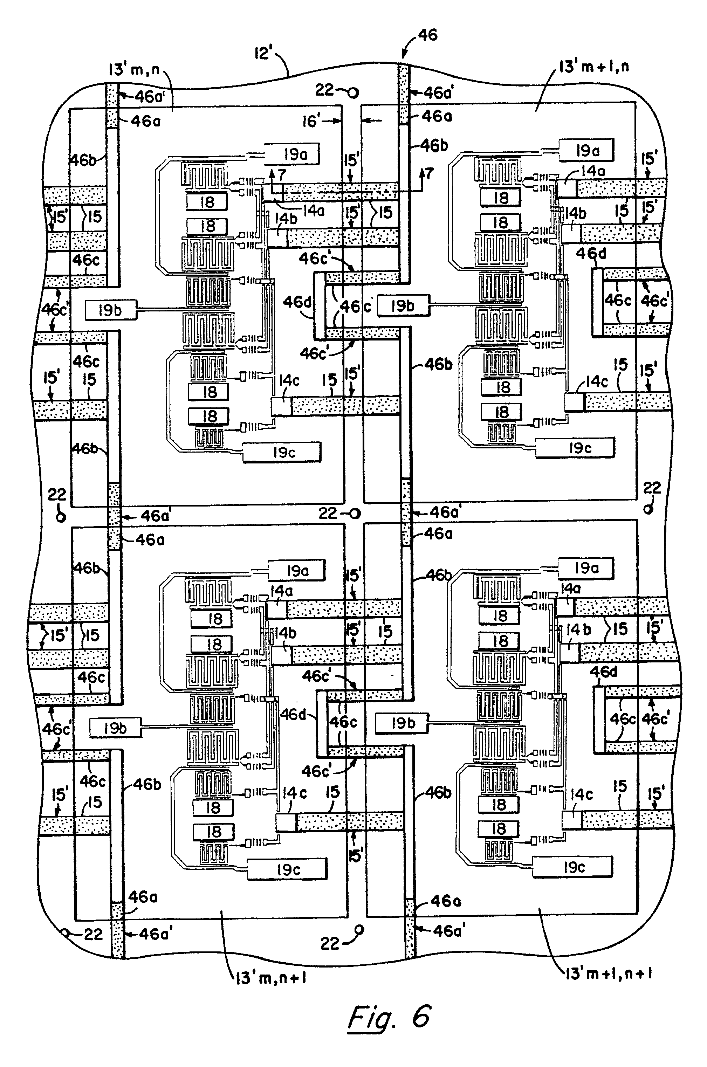

Referring now to FIG. 6, an alternate embodiment of the present invention is shown, in which a portion of semiconductor substrate 12' supports a plurality of monolithic microwave integrated circuits $13'_{m,n}$ to $13'_{m+l,n+l}$. Each of the individual circuits supported by the substrate 12', including $13'_{m,n}$ to $13'_{m+l,n+l}$ are 1x2 switching circuits comprised of elements as described in conjunction with FIGS. 1 and 4. The substrate also includes alignment markers 22 as described in conjunction with FIG. 1. Each integrated circuit $13'_{m,n}$ to $13'_{m+l,n+l}$ further includes conductive regions 15 disposed to connect common gate pads 14a-14c to interconnecting conductors 46. The common gate pads 14a-14c are disposed over, and electrically connected to conductive regions 15 comprised of any conductive material such as metal or doped semiconductor, here comprised of doped GaAs having a silicon dopant concentration greater than $2 \times 10^{17}$ carrier/cm$^3$. Interconnecting conductors 46 further include vertically disposed conductor portions 46a, 46b, and 46d, and horizontally disposed conductor portions 46c. As described in conjunction with FIG. 1, the integrated circuits $13'_{m,n}$ to $13'_{m+l,n+l}$ are spaced by portions of the substrate 12' which form a grid pattern 16'. Vertical conductors 46b and 46d are disposed over portions of the substrate 12' which support the integrated circuits $13'_{m,n}$ to $13'_{m+l,n+l}$ and may be comprised of any conductive material; however, metal is preferable since it typically has low resistivity which will minimize the error of the test results. Conductor portions 46a and 46c of interconnecting conductor 46 and conductor portions 15' of conductive regions 15 are disposed in the grid pattern 16' of the substrate 12' which spaces the integrated circuits $13_{m,n}$ to $13_{m+l,n+l}$ and are comprised of any conductive material such as a metal or suitably doped semiconductor but preferably suitably doped semiconductor or some other non-metallic conductive material.

Conductor portions 46a and 46c are preferably comprised of a material other than metal because the presence of metal in the grid pattern 16' of the substrate 12' may be detrimental to certain methods of separating the substrate 12' into individual integrated circuits $13'_{m,n}$ to $13'_{m+l,n+l}$. For example, if the substrate 12' were divided by the method of sawing, metal located in the grid pattern 16' of the substrate 12', where the separation occurs, could over time decrease the effectiveness of the saw blade. Moreover, if the semiconductor substrate 12' is separated by the method of scribing and then snapping the substrate 12' apart into individual integrated circuits $13'_{m,n}$ to $13'_{m+1,n+1}$, then the embodiment of FIG. 6 is preferred in order to ensure that no residual connection between common gate pads 14a-14c remains.

There are many ways to route the interconnecting conductor 46 such that metal portions thereof remain on the portions of the substrate 12' which support the integrated circuits $13'_{m,n}$ to $13'_{m+1,n+1}$ and not on in grid pattern 16' of the substrate 12'. The criteria for such routing is to have the grid pattern 16' of the substrate 12' free of metal and to ensure that, after the substrate 12' is divided into individual integrated circuits $13'_{m,n}$ to $13'_{m+1,n+1}$, the common gate pads 14a-14c are no longer electrically connected.

As shown in FIG. 6, metal vertically disposed conductor portion 46d is disposed on circuit $13'_{m,n}$ rather than on adjacent circuit $13'_{m+1,n}$ because if it were disposed on circuit $13'_{m+1,n}$ it might not comply with military specifications regarding the distance required between metal conductors disposed on a semiconductor substrate.

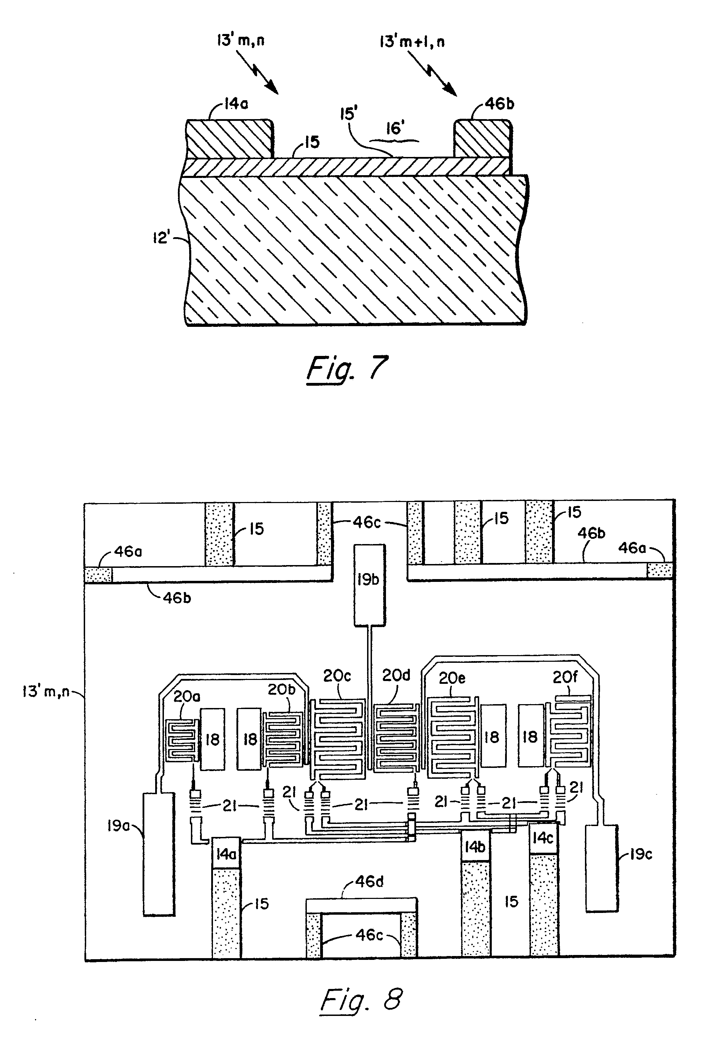

Referring now to FIG. 7, a portion of semiconductor substrate 12' is shown supporting adjacent integrated circuits $13'_{m,n}$ and $13'_{m+1,n}$. Common gate pad 14a of integrated circuit $13'_{m,n}$ is disposed over and in electrical contact with conductive region 15. The conductive region 15 is further disposed in contact with metal, vertically disposed conductor portion 46b of interconnecting conductor 46. The grid portion 16' of the substrate 12' which spaces integrated circuits $13'_{m,n}$ and $13'_{m+1,n}$ is void of any metal.

Referring now to FIG. 8, an individual integrated circuit $13'_{m,n}$ after dicing of the semiconductor substrate 12' is shown having common gate pads 14a-14c disposed over and in electrical contact with conductive regions 15 of GaAs doped as described in conjunction with FIG. 6. The integrated circuit $13'_{m,n}$ further includes vertically and horizontally disposed conductor portions 46a-46d of interconnecting conducto 46. The conductive regions 15 disposed between the common gate pads 14a-14c and the edges of the integrated circuit $13'_{m,n}$ would have been electrically connected to conductive regions 15 of adjacent integrated circuits before the substrate 12' was divided into individual circuits $13'_{m,n}$ to $13'_{m+1,n+1}$, as shown in FIG. 6. The metal vertically disposed conductor portions 46b and 46d are disposed entirely on the integrated circuit $13'_{m,n}$ therefore ensuring no metal on the grid pattern 16' of the substrate 12'.

Having described preferred embodiments of the invention, it will now become apparent to one of skill in the art that other embodiments incorporating their concepts may be used. It is felt, therefore, that these embodiments should not be limited to disclosed embodiments, but rather should be limited only by the spirit and scope of the appended claims.

## Claims

1. A semiconductor structure, comprising:
   a semiconductor substrate;
   a plurality of integrated circuits supported by the substrate, with each circuit having at least one electrode; and
   means, disposed on said substrate, for interconnecting the electrode of one of the plurality of integrated circuits with the electrode of another one of the plurality of integrated circuits.

2. The structure as recited in Claim 1 wherein the integrated circuits are spaced by portions of the substrate and wherein the means for interconnecting electrodes is disposed over at least part of said portions.

3. The structure as recited in Claim 2 wherein each one of the plurality of integrated circuits further comprises at least one conductive region disposed between said electrode and said portions of the substrate, and wherein the means for interconnecting the electrodes includes said conductive regions.

4. The structure as recited in Claim 3 wherein the conductive regions are comprised of doped GaAs.

5. The structure as recited in Claim 3, wherein the means for interconnecting electrodes is comprised of a metal.

6. The structure as recited in Claim 1 wherein the means for interconnecting the electrodes has portions thereof disposed on the plurality of integrated circuits and portions disposed in regions of the substrate spacing said plurality of integrated circuits.

7. The structure as recited in Claim 6 wherein each one of the plurality of integrated circuits further comprises at least one conductive region disposed between the electrode and an adjacent one of the plurality of integrated circuits and wherein the means for interconnecting electrodes includes said conductive regions.

8. The structure as recited in Claim 7 wherein the conductive regions are comprised of doped GaAs.

9. The structure as recited in Claim 7 wherein the means for interconnecting the conductive regions is a metal.

10. An integrated circuit, comprising:
   at least one electrode; and
   at least one conductive region disposed between said electrode and an edge of the integrated circuit.

11. The structure as recited in Claim 10 wherein the conductive region is comprised of doped GaAs.

12. An integrated circuit comprising:
   at least one electrode;
   at least one conductive region disposed between said electrode and an edge of the integrated circuit; and
   at least one conductor disposed in contact with said conductive region.

13. The structure as recited in Claim 12 wherein the conductive region is comprised of doped GaAs.

14. The structure as recited in Claim 12 wherein the conductor is comprised of a metal.

15. A method of testing integrated circuits comprising the steps of:
   providing a substrate supporting a plurality of integrated circuits each one of said circuits having a first and a second electrode;
   interconnecting the first electrodes of each one of said circuits; and
   disposing a pair of test probes on said circuits with the first test probe electrically connected to the interconnecter first electrodes and the second test probe electrically connected to the second electrode of a first one of said circuits.

16. The method of Claim 15 further comprising the step of: electrically connecting the second test probe to the second electrode of a second, different one of said circuits.

_Fig. 1_

*Fig. 2*

*Fig. 4*

*Fig. 3*

*Fig. 5*

*Fig. 6*

*Fig. 7*

*Fig. 8*